# FASCICULE DE BREVET EUROPEEN

(11) **EP 0 681 419 B1**
(45) Date de publication et mention de la délivrance du brevet: **08.08.2001**
(21) Numéro de dépôt: 95400891.8
(22) Date de dépôt: 21.04.1995
(51) Int. Cl.: H05K 5/00, G12B 9/02

(54) **Module additif connectable à un appareil électrique portatif et autonome**
Zusatzmodul mit einem elektrischen tragbaren und unabhängigen Gerät verbindbar
Supplementary module connectable to an electric portable self-contained apparatus

(30) Priorité: 06.05.1994 FR 9405780
(43) Date de publication de la demande: 08.11.1995
(73) Titulaire: ETAT-FRANCAIS représenté par le DELEGUE GENERAL POUR L'ARMEMENT (DPAG), F-75996 Paris Armées (FR); PROENGIN S.A., 78210 Saint-Cyr-l'Ecole (FR)
(72) Inventeur: Bleuse, Patrick, F-59530 le Quesnoy (FR); Clausin, Pierre, F-92410 Ville d'Avray (FR); Henriot, Pierre, F-91420 Morangis (FR); Lecoustey, Bernard, F-91220 Bretigny/Orge (FR); Strub, Thierry, F-92310 Sevres (FR)

(56) Documents cités:
- WO-A-88/06727
- FR-A- 2 404 228
- US-A- 4 038 535
- PATENT ABSTRACTS OF JAPAN vol. 17 no. 539 (P-1621) ,28 Septembre 1993 & JP-A-05 150061 (HARAGUCHI) 18 Juin 1993,

## Description

La présente invention concerne un module additif spécialement conçu pour se connecter à un appareil électrique et électronique portatif et autonome tel que, par exemple, un appareil pour l'analyse in situ d'une composition gazeuse.

Ce module a plus particulièrement pour but de compléter et/ou de modifier les fonctions de l'appareil par exemple pour effectuer des lectures mémoires, des téléchargements, des transmissions à distance d'informations ainsi que des tests de fonctionnement et/ou des diagnostics de pannes.

Elle s'applique plus particulièrement aux appareils portatifs et autonomes utilisant une source d'alimentation amovible telle que, par exemple, une batterie de piles ou d'accumulateur venant se loger dans un magasin réalisé dans le boîtier de l'appareil. En général, ce magasin est accessible de l'extérieur grâce à une trappe refermée par un couvercle amovible que l'on peut ouvrir pour introduire ou pour ôter la source d'alimentation. La trappe peut être ensuite refermée de manière à obturer, de préférence de façon étanche, le magasin. Bien entendu, ce dernier est équipé de moyens de connexion coopérant avec un connecteur prévu sur la source.

Un avantage de cette solution consiste en ce que la source d'alimentation de même que les connexions électriques entre cette source et les circuits électriques de l'appareil, se trouvent efficacement protégés aussi bien contre les chocs que vis-à-vis de l'eau et de l'humidité.

Habituellement, la connexion d'additifs sur des appareils de ce genre fait nécessairement intervenir des éléments de connexion accessibles de l'extérieur du boîtier. La réalisation de tests implique quant à elle, soit un démontage de l'appareil pour pouvoir accéder aux bornes de test situées à l'intérieur du boîtier, soit la présence de connecteurs extérieurs dont les broches sont reliées aux bornes de test du circuit de l'appareil.

Il est clair que l'usage de connecteurs extérieurs complique la réalisation du boîtier, lequel doit en outre comprendre des moyens de protection et d'étanchéité de ces connecteurs. Par ailleurs, le démontage de l'appareil en vue d'accéder à ses circuits est proscrit en dehors de zones protégées notamment contre la poussière, l'humidité, etc...

Du document US-A-4 038 535 est connu le fait de raccorder une imprimante à une calculatrice de poche par l'intermédiaire du logement des batteries de la calculatrice, après avoir retiré lesdites batteries.

L'invention a donc plus particulièrement pour but de supprimer ces inconvénients. Elle propose un additif modulaire dont la connexion à l'appareil n'implique aucune complication du boîtier, et est cependant assurée avec un maximum de protection, notamment contre l'humidité, à l'aide de connecteurs eux-mêmes protégés lorsqu'ils ne sont pas utilisés.

Pour parvenir à ces résultats, l'invention propose un module additif pour un appareil électrique ou électronique portatif et autonome pouvant être alimenté par une source d'énergie électrique amovible se logeant dans un magasin accessible de l'extérieur, caractérisé en ce qu'il comprend:
- des moyens électroniques aptes à effectuer des compléments et/ou des modifications de fonction de l'appareil,
- des moyens communs d'alimentation en énergie électrique de ces moyens électroniques et de l'appareil,
- des moyens de connexion électrique aptes à coopérer avec des moyens de connexion correspondants prévus dans le magasin,
- des moyens assurant l'étanchéité avec le magasin, ces quatre types de moyens étant portés par une structure conformée pour être engagée à la façon d'un tiroir à l'intérieur du magasin, en remplacement de la source d'énergie électrique amovible.

Avantageusement, le module additif peut en outre comprendre des moyens de dialogue avec un opérateur, disposés à l'extérieur du boîtier de l'appareil, lorsque le module est engagé à fond dans le magasin, les connexions électriques entre le module et l'appareil étant établies.

Il est clair que grâce à ces dispositions, en fonctionnement normal de l'appareil, les éléments de connexion sont protégés à l'intérieur du magasin, lequel est fermé, de façon étanche par le couvercle.

De même, lorsque le module est engagé à fond dans le magasin, la protection des connexions module/appareil peut être facilement renforcée en prévoyant des garnitures d'étanchéité entre le boîtier du module et celui de l'appareil.

Un autre avantage de cette solution consiste en ce que l'additif peut comprendre des moyens d'alimentation calibrés, de manière à s'affranchir des défectuosités de la source d'alimentation usuelle, notamment lorsqu'on effectue les tests.

Des modes d'exécution de l'invention seront décrits ci-après, à titre d'exemples non limitatifs, avec référence aux dessins annexés dans lesquels :
La figure 1 est une coupe axiale dans un premier plan d'un additif modulaire conçu de manière à venir s'engager dans le magasin à piles d'un appareil électrique ;
La figure 2 est une coupe axiale dans un plan perpendiculaire à celui de la figure 1 de la tête de l'additif modulaire incluant des moyens de dialogue ;
La figure 3 est une coupe longitudinale dans un plan horizontal d'une variante d'exécution d'un additif modulaire dont les deux parties sont désassemblées ;
Les figures 4 et 5 représentent en coupe longitudinale et vue de face, la tête de l'additif de la figure 3 ;
La figure 6 est une vue partiellement en coupe axiale verticale de l'additif représenté figure 3 avec ses deux parties assemblées l'une à l'autre.

Les additifs modulaires représentés sur ces figures sont destinés à se connecter sur un appareil portatif et autonome pour l'analyse d'une composition gazeuse par spectrométrie de flamme tel que celui qui se trouve décrit dans le brevet FR No 87 02762 au nom de PROENGIN. Un tel appareil comprend un brûleur muni d'une fenêtre dans l'axe de laquelle est disposé un dispositif de spectrométrie de flamme comportant :
- une optique focalisatrice du rayonnement émis par la flamme ;
- un hacheur faisant intervenir une pluralité de filtres optiques, à raison de un par raie spectrale caractéristique de l'élément recherché ;
- une cellule optoélectronique placée dans la zone de focalisation de ladite optique ;
- un ensemble de démodulation du signal électrique délivré par ladite cellule ; et
- des moyens d'amplification et d'affichage du signal électrique délivré par ledit ensemble.

La combustion du gaz à l'intérieur du brûleur s'effectue dans un courant d'hydrogène à débit constant obtenu par le chauffage d'éléments tels que des granulés de lanthane-nickel imprégnés d'hydrogène et contenus dans une cartouche interchangeable de faible volume. Dans ce dispositif, le dispositif de chauffage est asservi à la pression d'hydrogène d'un régulateur qui alimente à débit constant le brûleur en hydrogène.

L'alimentation en énergie électrique du brûleur est habituellement assurée par des piles ou des batteries d'accumulateur venant se loger dans un magasin obturé, de façon étanche, par un couvercle.

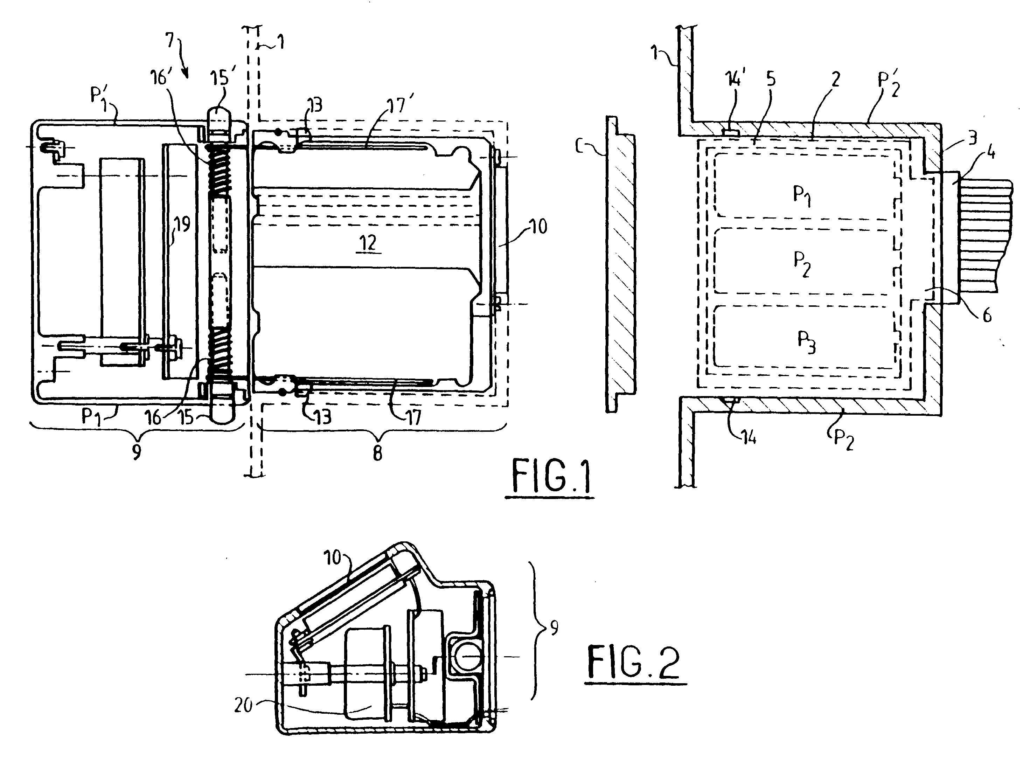

Dans l'exemple représenté sur la figure 1, seule la partie arrière 1 du boîtier de l'appareil incluant le magasin 2 a été représentée schématiquement.

Ce magasin 2 présente une forme prismatique, de section sensiblement rectangulaire dont le fond 3 est muni d'un premier élément de connexion 4 dont les broches sont respectivement connectées en différents points du circuit de l'appareil et, en particulier, des points concernés par les tests. Au moins deux de ces broches sont connectées à deux bornes d'alimentation correspondantes du circuit de l'appareil.

En fonctionnement normal, l'appareil peut recevoir une cartouche 5 de piles P₁, P₂, P₃ ou de batteries (en traits interrompus) de forme sensiblement complémentaire, munie d'un élément de connecteur 6 apte à venir s'accoupler à l'élément de connecteur 4 de manière à assurer une connexion électrique entre les bornes d'alimentation du circuit et les piles P₁-P₃. Le magasin est alors refermé de façon étanche grâce à un couvercle C pouvant éventuellement faire corps avec la cartouche 5.

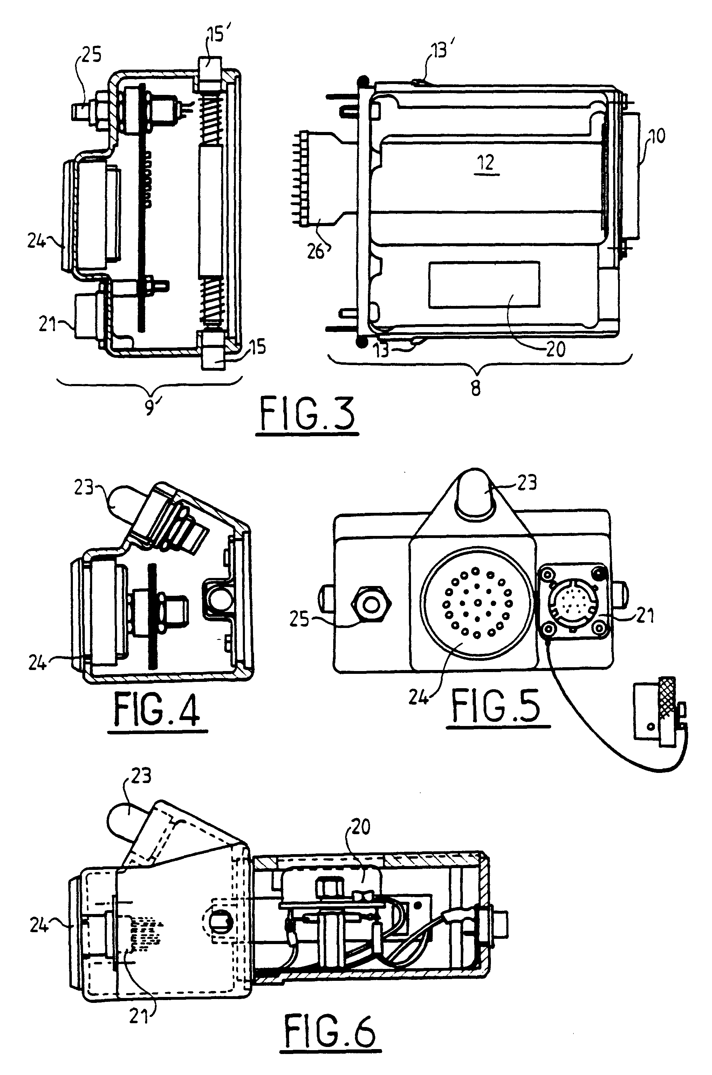

Conformément à l'invention, ce magasin est en outre destiné à recevoir à la place de la cartouche 5 un module additif par exemple du type de celui représenté sur les figures 1 et 2 ou celui représenté sur les figures 3 à 6.

Le module additif 7 représenté sur les figures 1 et 2 est destiné à la réalisation de tests et au diagnostic des pannes de l'appareil. Il permet non seulement de confirmer l'autotest interne de l'appareil, mais aussi le contrôle de bon fonctionnement des paramètres électriques accessibles grâce à l'élément de connexion. Il procède à des séquences de tests au cours desquelles il simule des conditions de fonctionnement différentes et vérifie la réaction et l'adaptation de l'appareil à ces configurations. Il comporte également ses propres capteurs de pression atmosphérique et de température afin de valider les mesures réalisées par l'appareil.

Le module additif permet notamment, en plus de la visualisation du numéro de fabrication de l'appareil et de son numéro de série, l'affichage du nombre d'heures d'utilisation de l'appareil. Il permet ainsi d'assurer le suivi et le déclenchement des opérations de maintenance préventive selon la périodicité souhaitée. Enfin, le module additif permet l'affichage en clair des concentrations en substances recherchées des gaz analysés par l'appareil.

Dans cet exemple, le module 7 est réalisé en deux parties, à savoir :
- un tiroir 8, structuralement similaire à la cartouche de piles ou de batteries 5, et qui présente donc une forme sensiblement complémentaire à celle du magasin 2 dans lequel il peut venir s'engager, et
- une tête 9 destinée à demeurer à l'extérieur lorsque le tiroir 8 se trouve engagé à fond dans le magasin 2, cette tête 9 comprenant un afficheur de type à cristaux liquides ainsi que des moyens de commande tels que des touches.

Le tiroir 8 renferme des piles ou des batteries servant aussi bien au fonctionnement de l'appareil qu'à l'alimentation du circuit électronique logé dans la tête 9. De la même façon que la cartouche 5, il comprend, en saillie sur sa face antérieure, un élément de connecteur multibroches 10 apte à venir s'engager sur l'élément de connecteur 4. Les broches de cet élément de connecteur 4 qui ne sont pas reliées aux piles ou aux batteries sont reliées au circuit électronique inclus dans la tête 9, par exemple au moyen d'un circuit imprimé souple multipistes 12.

Le verrouillage du tiroir 8 dans le magasin est assuré au moyen de deux verrous 13, 13' mobiles transversalement au travers de deux parois opposées du tiroir, de manière à pouvoir s'engager dans deux logements respectifs formant gâches 14, 14' des parois P₂, P'₂ du magasin 2.

L'actionnement des deux verrous 13, 13' est assuré par deux broches respectives 17, 17' actionnées par deux bouton-poussoirs correspondants 15, 15' rappelés par ressort 16, 16', qui passent au travers de deux parois opposées P₁, P'₁ de la tête 9, en correspondance avec les parois P₂, P'₂.

En position verrouillée, l'étanchéité entre le tiroir et les parois du magasin est obtenue au moyen d'un joint d'étanchéité J partiellement logé dans une gorge périphérique du boîtier du tiroir.

La tête 9 renferme une carte électronique 19 équipée d'un microcontrôleur ainsi que des capteurs internes 20 notamment de pression et de température. Grâce à un logiciel spécifique, ce microcontrôleur gère les échanges d'informations entre l'appareil et le module additif, par exemple par une liaison de type RS 232, notamment en ce qui concerne les acquisitions et les mesures des différents signaux prélevés sur l'élément de connecteur 4 ainsi qu'au niveau des capteurs internes de l'appareil. Il procède en outre à la visualisation, sur l'afficheur, des différentes informations.

Dès la mise sous tension, le microcontrôleur entreprend une séquence de dix tests réalisés en synchronisme avec l'allumage de l'appareil, cette séquence comprenant plus particulièrement :
- la vérification des paramètres d'étalonnage,
- la vérification des mesures d'environnement,
- la vérification de la tension de commande de la turbine de circulation d'air dans le brûleur,
- la vérification du chauffage du générateur d'hydrogène,
- la vérification de l'horloge de l'échantillonneur,
- la vérification de la pression d'hydrogène,
- la vérification de l'allumage,
- la vérification de la flamme,
- la vérification des signaux d'analyse,
- la vérification de l'indicateur de pannes de l'appareil.

Le microcontrôleur confirme ensuite la validité des paramètres d'étalonnage, positionne l'appareil dans des configurations de fonctionnement extrêmes, compare la validité des mesures atmosphériques, affiche des messages de diagnostic de même que des messages et des codes d'aide à la séparation, ainsi que le numéro de l'appareil et sa série. Il peut en outre afficher le nombre d'heures d'utilisation de l'appareil ainsi que les concentrations en agents recherchés.

Le module additif illustré sur les figures 3 à 6 est plus particulièrement destiné à transformer l'appareil d'analyse de composition gazeuse précédemment mentionné, en un détecteur d'alerte portatif et/ou en un appareil de contrôle de contamination chimique qui déclenche une alerte lorsque le débit de dose détecté dépasse un seuil prédéterminé.

Il comprend un tiroir 8 de forme similaire à celui précédemment décrit mais qui renferme au lieu des piles ou des batteries d'accumulateur, un circuit d'alimentation 20 dont la sortie est connectée à des broches correspondantes du connecteur 10 tandis que son entrée est reliée à un connecteur multibroches 21 prévu sur la face antérieure de la tête. Ce connecteur 21 de type classique est refermé par un capot de protection 22, permet une connexion électrique par exemple à une source d'énergie électrique équipant un véhicule.

Dans cet exemple, la tête 9' comprend au niveau de sa face antérieure, en plus du connecteur 21, un voyant lumineux 23, une alarme sonore 24 et un interrupteur 25.

Elle loge un microcontrôleur apte à intégrer dans le temps la concentration en agent recherché et à déclencher une alarme à la fois optique et sonore lorsque le débit de dose ainsi déterminé a dépassé le susdit seuil.

L'alerte peut être ensuite acquittée en actionnant l'interrupteur 25 pendant une durée prédéterminée, par exemple six secondes, ou de façon automatique lorsque la dose est repassée au-dessous d'une valeur prédéterminée.

Le connecteur multibroches équipant la tête peut en outre recevoir un élément de connexion d'un dispositif permettant d'effectuer un report à distance d'informations telles que, par exemple :
- un report d'alerte par liaison bifilaire,
- un report d'affichage d'informations pouvant comprendre les paramètres internes de l'appareil et les paramétrages des seuils de contamination,
- un report de l'acquittement des alertes,
- une liaison numérique permettant le report d'informations.

Dans cet exemple, le circuit imprimé souple multipistes 12 est en outre relié à un élément de connecteur 26 pouvant s'engager dans un élément de connecteur correspondant prévu dans la tête 9'. Avantageusement, des moyens d'isolation galvanique tels que des optocoupleurs pourront être prévus de manière à ce que les informations transitant par la tête 9' soient sujettes à des perturbations (interférences).

## Revendications

1. Module additif pour un matériel électrique ou électronique portatif et autonome pouvant être alimenté par une source d'énergie électrique amovible (5) se logeant dans un magasin(2) accessible de l'extérieur,
caractérisé en ce qu'il comprend :
- des moyens électroniques (19) aptes à effectuer des compléments et/ou des modifications de fonction de l'appareil,
- des moyens communs d'alimentation en énergie électrique de ces moyens électroniques (19) et de l'appareil,
- des moyens de connexion électrique (10) aptes à coopérer avec des moyens de connexion correspondants (4) prévus dans le magasin (2),
- des moyens assurant l'étanchéité avec le magasin (2), ces quatre types de moyens étant portés par une structure(8) conformée pour être engagée à la façon d'un tiroir à l'intérieur du magasin (2), en remplacement de la source d'énergie électrique amovible (5).

2. Module additif selon la revendication 1, caractérisé en ce qu'il comprend des moyens de dialogue (10).

3. Module additif selon l'une des revendications 1 et 2, caractérisé en ce que les susdits moyens d'alimentation consistent en une batterie de piles ou d'accumulateurs.

4. Module additif selon l'une des revendications 1 et 2, caractérisé en ce que les susdits moyens d'alimentation consistent en un circuit d'alimentation (20) connecté à une source d'énergie électrique extérieure par l'intermédiaire d'un connecteur (21) prévu sur la partie du boîtier du module ressortant du susdit magasin.

5. Module additif selon l'une des revendications 1 à 4,
caractérisé en ce qu'il est réalisé en deux parties déconnectables, à savoir :
- un tiroir (8) présentant une forme sensiblement complémentaire à celle du magasin (2) destiné à être engagé dans le magasin, ce tiroir (8) renfermant les moyens d'alimentation et comprenant un élément de connexion (10) apte à venir s'engager sur un élément de connexion correspondant (4) du magasin (2), et
- une tête (9) comprenant un afficheur (10), des moyens de commande tels que des touches et un microcontrôleur qui gère les échanges d'informations entre l'appareil et le module.

6. Module additif selon la revendication 5, caractérisé en ce que son verrouillage dans le magasin (2) est assuré au moyen de deux verrous (13, 13'), mobiles transversalement au travers de deux parois opposées du tiroir (8), de manière à pouvoir s'engager dans deux logements respectifs (14,14') des paroi (P2, P'2) du magasin (2), ces verrous (13, 13') étant actionnés par deux broches (17, 17') mues par deux boutons-pressoirs (15, 15') qui passent au travers de deux parois opposées (P1 P'1) de la tête (9).

7. Module additif selon l'une des revendications 1 à 6, caractérisé en ce qu'il est équipé de capteurs, notamment de température et de pression.

8. Module additif selon l'une des revendications 1 à 7, caractérisé en ce qu'il est équipé d'un témoin visuel ou sonore.

9. Application du module additif selon l'une des revendications 1 à 8, au test de fonctionnement et de diagnostic de pannes d'un appareil portatif et autonome d'analyse d'une composition gazeuse par spectrométrie de flamme.

10. Application du module additif selon la revendication 7, à la validation des mesures d'un appareil portatif et autonome d'analyse d'une composition gazeuse par spectrométrie de flamme.

11. Application du module additif selon la revendication 8, au contrôle, à la détection d'agents de contamination chimique et à l'alerte lorsque le débit de dose détecté dépasse un seuil prédéterminé.

## Claims

1. Add-on module for portable stand-alone electrical or electronic equipment adapted to be supplied by a removable source of electric power (5) accommodated in a magazine (2) which is accessible from the exterior, characterised in that it comprises:
- electronic means (19) capable of complementing and/or modifying operation of the apparatus,
- common means for supplying these electronic means (19) and the apparatus with electric power,
- electrical connecting means (10) capable of cooperating with corresponding connecting means (4) provided in the magazine (2),
- means for producing the seal with the magazine (2), these four types of means being carried by a structure (8) configured so as to be engaged inside the magazine (2) in the manner of a slide element, as a substitute for the removable source of electric power (5).

2. Add-on module according to claim 1, characterised in that it comprises dialogue means (10).

3. Add-on module according to any of claims 1 and 2, characterised in that the aforementioned supply means consist of a battery of cells or accumulators.

4. Add-on module according to any of claims 1 and 2, characterised in that the aforementioned supply means consist of a supply circuit (20) connected to an external source of electric power by a connector (21) provided on the portion of the module casing projecting from said magazine.

5. Add-on module according to any of claims 1 to 4, characterised in that it is produced in two disconnectable portions, namely:
- a slide element (8) having a shape substantially complementary to that of the magazine (2) intended to be engaged in the magazine, this slide element (8) containing the supply means and comprising a connecting element (10) capable of engaging with a corresponding connecting element (4) of the magazine (2), and
- a head (9) comprising a display panel (10), control means such as keys and a microcontroller which manages the exchange of information between the apparatus and the module.

6. Add-on module according to claim 5, characterised in that it is locked in the magazine (2) by two bolts (13, 13') which can be moved transversely through two opposing walls of the slide element (8) so as to be able to engage in two respective recesses (14, 14') in the walls (P2, P'2) of the magazine (2), these bolts (13, 13') being actuated by two pins (17, 17') moved by two pushbuttons (15, 15') passing through two opposing walls (P1, P'1) of the head (9).

7. Add-on module according to any of claims 1 to 6, characterised in that it is equipped with sensors, in particular temperature and pressure sensors.

8. Add-on module according to any of claims 1 to 7, characterised in that it is equipped with a visual or audible signal.

9. Use of the add-on module according to any of claims 1 to 8 for the service and diagnostic testing of malfunctions of a portable stand-alone apparatus for analysing a gaseous composition by flame spectrometry.

10. Use of the add-on module according to claim 7 for validating the measurements of a portable stand-alone apparatus for analysing a gaseous composition by flame spectrometry.

11. Use of the add-on module according to claim 8 for monitoring, for the detection of chemical pollutants and for producing a warning when the detected dose rate exceeds a predetermined threshold.

## Patentansprüche

1. Zusatzmodul für ein tragbares und selbständiges elektrisches oder elektronisches Gerät, das von einer entnehmbaren elektrischen Energiequelle (5) versorgt werden kann, die sich in einem von außen zugänglichen Magazin befindet, dadurch gekennzeichnet daß es umfaßt:
- elektronische Mittel (19), die Ergänzungen und/oder Abwandlungen der Gerätefunktion ausführen können,
- gemeinsame Mittel, die diese elektronischen Mittel (19) und das Gerät mit elektrischer Energie versorgen,
- Mittel (10) für die elektrische Verbindung, die mit in dem Magazin (2) vorgesehenen entsprechenden Verbindungsmitteln (4) zusammenwirken können,
- Mittel, die die Dichtheit mit dem Magazin (2) gewährleisten, wobei diese vier Typen von Mitteln von einer Struktur (8) getragen werden, die so beschaffen ist, daß sie in der Art eines Einschubs im Magazin (2) angebracht werden kann, indem sie die entnehmbare Quelle (5) für elektrische Energie ersetzt

2. Zusatzmodul nach Anspruch 1, dadurch gekennzeichnet, daß es Dialogmittel (10) umfaßt.

3. Zusatzmodul nach einem der Ansprüche 1 und 2, dadurch gekennzeichnet, daß die genannten Versorgungsmittel aus einer Zellen- oder Akkumulatorbatterie bestehen.

4. Zusatzmodul nach einem der Ansprüche 1 und 2, dadurch gekennzeichnet, daß die genannten Versorgungsmittel aus einer Versorgungsschaltung (20) bestehen, die mit einer äußeren Quelle für elektrische Energie über einen Verbinder (21) verbunden ist, der in dem vom Magazin vorstehenden Teil des Modulgehäuses vorgesehen ist.

5. Zusatzmodul nach einem der Ansprüche 1 bis 4, dadurch gekennzeichnet, daß es aus zwei trennbaren Teilen hergestellt ist, nämlich:
- einem Einschub (8), der eine Form besitzt, die zu derjenigen des Magazins (2) im wesentlichen komplementär ist, und dazu bestimmt ist, in das Magazin eingesetzt zu werden, wobei dieser Einschub (8) die Versorgungsmittel verschließt und ein Verbindungselement (10) umfaßt, das mit einem entsprechenden Verbindungselement (4) des Magazins (2) in Eingriff gelangen kann, und
- einem Kopf (9), der eine Anzeigeeinheit (10), Steuermittel wie etwa Tasten sowie einen Mikrocontroller, der den Austausch von Informationen zwischen dem Gerät und dem Modul steuert, enthält.

6. Zusatzmodul nach Anspruch 5, dadurch gekennzeichnet, daß seine Verriegelung im Magazin (2) mittels zweier Riegel (13, 13') gewährleistet ist, die durch zwei gegenüberliegende Wände des Einschubs (8) in der Weise transversal beweglich sind, daß sie in zwei entsprechende Aufnahmesitze (14, 14') der Wände (P2, P'2) des Magazins (2) eingreifen können, wobei diese Riegel (13, 13') durch zwei Stifte (17, 17') betätigt werden, die durch zwei Druckknöpfe (15, 15') bewegt werden, die durch zwei gegenüberliegende Wände (P1, P'1) des Kopfes (9) verlaufen.

7. Zusatzmodul nach einem der Ansprüche 1 bis 6, dadurch gekennzeichnet, daß es mit Sensoren, insbesondere Temperatur- und Drucksensoren, ausgerüstet ist.

8. Zusatzmodul nach einem der Ansprüche 1 bis 7, dadurch gekennzeichnet, daß es mit einem optischen oder akustischen Anzeiger ausgerüstet ist.

9. Anwendung des Zusatzmoduls nach einem der Ansprüche 1 bis 8 auf eine Funktions- und Fehlerdiagnose-Prüfung eines tragbaren und selbständigen Geräts für die Analyse einer gasförmigen Verbindung mittels Flammenspektroskopie.

10. Anwendung des Zusatzmoduls nach Anspruch 7 auf die Validierung von Meßwerten eines tragbaren und selbständigen Geräts für die Analyse einer gasförmigen Verbindung mittels Flammenspektroskopie.

11. Anwendung des Zusatzmoduls nach Anspruch 8 auf die Kontrolle, auf die Erfassung von chemischen Verunreinigungsagenzien und auf den Alarm, wenn die erfaßte Dosisrate einen vorgegebenen Schwellenwert übersteigt.
